# EUROPEAN PATENT SPECIFICATION

(11) **EP 3 009 883 B1**
(45) Date of publication and mention of the grant of the patent: **24.05.2017**
(21) Application number: 15185835.4
(22) Date of filing: 18.09.2015
(51) Int. Cl.: G02F 1/1345

(54) **NARROW BEZEL FLAT PANEL DISPLAY AND METHOD FOR MANUFACTURING THE SAME**
FLACHBILDSCHIRMANZEIGE MIT SCHMALEM RAHMEN UND VERFAHREN ZU DEREN HERSTELLUNG
ÉCRAN PLAT À LUNETTE ÉTROITE ET SON PROCÉDÉ DE FABRICATION

(30) Priority: 14.10.2014 KR 20140138624
(43) Date of publication of application: 20.04.2016
(73) Proprietor: LG Display Co., Ltd., Seoul 07336 (KR)
(72) Inventor: LEE, Sangwook, Gyeonggi-do 413-010 (KR); PARK, Kibok, Eunpyeong-gu 122-120 (KR)
(74) Representative: Ter Meer Steinmeister & Partner

(56) References cited:
- US-A1- 2007 021 007
- US-B1- 6 211 936

## Description

### BACKGROUND

### Field

This document relates to a narrow bezel flat panel display, and more particularly to a narrow bezel flat panel display where an additional space in which a connection member is disposed along one end of a thin film transistor substrate is removed, and to a method for manufacturing the same.

### Related Art

There have been rapid developments in display devices, among which Flat Panel Display devices (FPDs), which are thin and light, and capable of being manufactured to be large-area flat panel displays, are used to replace a Cathode Ray Tube (CRT) having bulky volume. Examples of the FPD include a Liquid Crystal Display Device (LCD), a Plasma Display Panel (PDP), an Organic Light Emitting Display Device (OLED), an Electrophoretic Display Device (EPD), and the like, among which the LCD displays images by controlling electric fields applied to liquid crystal molecules according to a data voltage. An active matrix type LCD, which may be manufactured with low costs and high performance achieved by the development of processing and operating technologies, is most widely used in applications of almost all display devices ranging from small mobile devices to large televisions.

Recently, with an increasing demand for a flat panel display and with the development of the flat panel display technology, there have been various demands regarding external designs of the LCD from an aesthetic point of view, including an increasing demand for a flat panel display with a reduced bezel area.

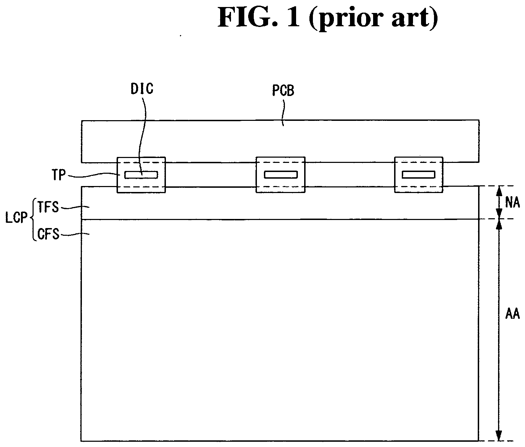

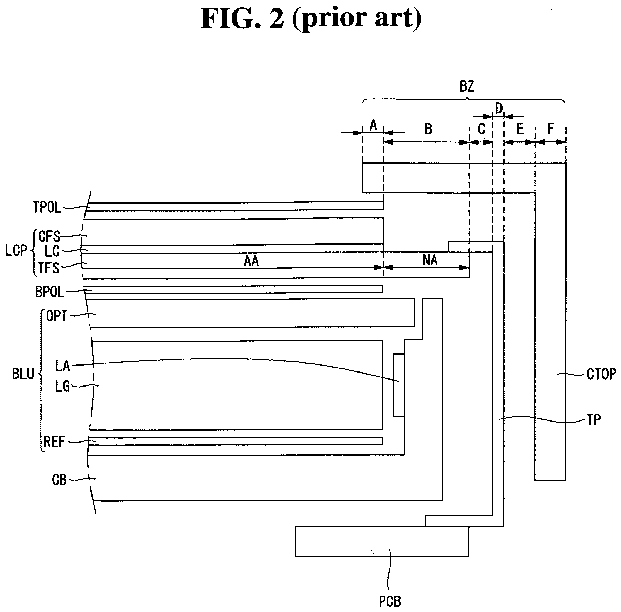

As a way of reducing a bezel area, a printed circuit board (PCB) may be disposed on the rear surface of a display panel to thereby reduce a non-display area of the display panel. Hereinafter, a structure of a general liquid crystal display is described by reference to FIGS. 1 and 2. FIGS. 1 and 2 are diagrams illustrating a structure of a general liquid crystal display.

The general LCD includes a display panel LCP, a backlight unit BLU that emits light to the display panel LCP, and a driving unit that drives the display panel LCP.

The display panel LCP includes a thin film transistor substrate TFS on which a display area AA and a non-display area NA are defined, a color film substrate CFS that is disposed on an upper surface of the AA, and a liquid crystal cell LC that is interposed between the thin film transistor substrate TFS and the color film substrate CFS.

A color filter having a pattern of red, green, and blue, or having a pattern of red, green, blue, and white is formed on the color filter substrate CFS. In addition, a black matrix may be further formed thereon.

A plurality of gate lines that are arranged in one direction and a plurality of data lines that are arranged in a direction perpendicular to the gate lines are formed on the thin film transistor substrate TFS. Further, a plurality of pixel electrodes is arranged in a matrix form in a pixel area defined by the intersection of the gate lines and the data lines. A plurality of thin film transistors is formed that are switched according to signals of the gate lines to transmit signals of the data lines to each pixel electrode.

A liquid crystal cell LC is driven by a voltage difference between a pixel electrode that charges a data voltage through a thin film transistor and a common electrode to which a common voltage is applied. The common electrode may be formed on the color filter substrate CFS or on the thin film transistor substrate TFS depending on the types of a liquid crystal display.

In order to enable the display panel LCP to perform an optical function, a top polarizer TPOL may be formed on the front surface of the color filter substrate CFS, and a bottom polarizer BPOL may be formed on the rear surface of the thin film transistor substrate TFS. The top polarizer TPOL and the bottom polarizer BPOL are disposed such that light transmission axes thereof cross orthogonal to each other.

The backlight unit BLU is disposed on the rear surface of the display panel LCP, and includes a light source LA that generates light and a light guide plate LG that guides light from the light source LA to the display panel LCP. A reflection sheet REF is disposed on the rear surface of the light guide plate LG, and an optical sheet is disposed on the front surface of the light guide plate LG. The optical sheet OPT may include a diffusion sheet, a prism sheet, or a protective sheet.

A cover bottom CB is disposed on the bottom of the display panel LCP and the backlight unit BLU. The cover bottom CB needs to be formed in a manner that protects and supports the display panel LCP and the backlight unit BLU.

A driving unit that drives the display panel LCP is provided on at least one end side of the thin film transistor substrate TFS. The driving unit includes a printed circuit board PCB to drive the display panel LCP, and a drive integrated circuit DIC that is electrically connected to the printed circuit board PCB to supply signals to the display panel LCP. The DIC supplies signals to the gate lines or the data lines through a pad unit formed in the non-display area NA of the thin film transistor substrate TFS. The DIC is mounted on the connection member TP. For example, the connection member TP may be a Tape Carrier Package (TCP), in which one side of the connection member TP is connected to the thin film transistor substrate TFS by Tape Automated Bonding (TAB), and the other side thereof is connected to the PCB.

As such, the driving unit and the display panel LCP are formed separately and electrically connected to each other using the connection member (TP). For this configuration, an additional area where the connection member (TP) is able to be mounted is needed. Such an area increases a non-display area (AA), thereby increasing a bezel area.

For the narrow bezel structure, the printed circuit board PCB is disposed on the rear surface of the thin film transistor substrate TFS. As illustrated in FIG. 2, the PCB may be disposed on the bottom of the cover bottom CB. At this point, a case top CTOP is disposed to cover a edge of the color filter substrate CFS, the non-display area NA of the thin film transistor substrate TFS, and the driving unit.

Even in this case, there is limitation in reducing a bezel area by a connection member TP that connects the thin film transistor substrate TFS and the print circuit board PCB. Specifically, the connection member TP is disposed in a manner of bending along the circumference of an end side of the thin film transistor substrate TFS. Thus, there should be a predetermined distance C between the connection member TP and the thin film transistor substrate TFS in order to prevent mechanical interference between the thin film transistor substrate TFS and the connection member TP. In addition, to prevent damage of the connection member TP having ductility properties, there should be a predetermined distance E between the connection member TP and the case top CTOP. Thus, the general liquid crystal display has a limitation in reducing a bezel area. In particular, the minimum bezel width is defined by a width A, by which the case top CTOP covers the color filter substrate CFS, by a width B of a non-display area NA of the thin film transistor substrate TFS, by the distances C and E, as well as by the thickness D of the connection member TP and the thickness F of the case top CTOP. Since the bezel area degrades the aesthetic quality of a liquid crystal display, an effort for reducing the bezel area is needed.

US 6 211 936 B discloses a device having the features of the preamble of claim 1.

### SUMMARY

The objects are solved by the features of the independent claims. Preferred embodiments are defined by the dependent claims.

By providing a connection member for connecting a driving unit and a display panel within a recess or cut-out at an edge of a substrate of the display panel, the bezel area of the display device can be reduced.

According to one aspect, a flat panel display device is provided, including a display panel including a first substrate; a driving unit for driving the display panel, wherein the driving unit is mounted on a rear surface of the display panel; a connection member for electrically connecting the driving unit and the first substrate of the display panel; and a recess formed on an edge of the first substrate, wherein the connection member passes through the recess and is bent around the first substrate to the rear surface of the display panel. The edge may be a border or boundary of the first substrate, to which the driving unit may be connected. The rear surface of an element of the display device refers to a surface facing away from a user watching information displayed on the display device, while the front surface refers to a surface facing to the user. In other words, the directions front or rear refer to a common operational state of the display device.

The driving unit may include a printed circuit board or the like. Preferably, the driving unit and the display panel are formed separately.

The recess is preferably formed in a non-display area on the first substrate.

The recess may have a parallel side or boundary that is parallel to the edge of the first substrate. Further, the recess may have two connecting sides or boundaries connecting respectively an end of the parallel side to the edge of the first substrate. The connecting sides may be formed perpendicular to the parallel side. Thus, the recess may have a rectangular shape. Preferably, the connecting member may be bent around the parallel side of the recess.

Preferably, a (maximum) width or extension of the recess in a direction perpendicular to the edge is equal to or greater than a sum of a distance between the connection member and the parallel side of the recess and the thickness of the connection member.

A plurality of recesses may be provided. Here, one connection member may be provided within each recess. Alternatively, more than one connection member may be provided in the recess.

According to a preferred embodiment, the flat panel display device is a liquid crystal display device and the first substrate is a thin film transistor substrate, e.g. a substrate on which a plurality of gate lines and a plurality of data lines is formed.

The display device may further include a case top covering at least a lateral surface of the first substrate corresponding to the edge.

A (maximum) width of the recess in a direction perpendicular to the edge may be equal to or less than a sum of the distance between the connection member and the parallel side of the recess, the thickness of the connection member, and the distance between the connection member and the case top. Also, a distance between the connection member and the case top may be larger than a distance between a non-display area of the display panel and the case top. Generally, it may be referred to normal distances, i.e. the shortest distance between two elements. Also, the distances may refer to distances in a direction in a plane of the first substrate. Here, the distance between the connection member and the parallel side of the recess may refer to the distance between the parallel side of the recess and a portion of the connection member passing through the recess. Likewise, the thickness of the connection member may refer to the thickness in a direction in the plane of the first substrate. The distance between the connection member and the case top may also refer to the distance in a direction in a plane of the first substrate.

The device may further comprise a second substrate, e.g. a color filter substrate, and a top polarizer. Here, the top polarizer may cover a front surface of the second substrate and the non-display area of the first substrate. That is, the top polarizer may form a front surface of the display device. The case top may be disposed on a rear surface of the top polarizer. Thus, a zero-bezel device may be provided, i.e. there is no portion of the case top disposed on the front surface of the display device. Preferably, a space between the top polarizer and the first substrate is filled with a buffer material.

According to another aspect, a method is provided for manufacturing a flat panel display device having a driving unit for driving the display panel mounted on a rear surface of the display panel, the method including the steps of: preparing a first substrate; forming a recess on an edge of the first substrate; and connecting the driving unit and the first substrate electrically by means of a connection member, wherein the connection member passes through the recess and is bent around the first substrate to the rear surface of the display panel.

Preparing the first substrate may include disposing a pad unit spaced apart from the edge of the first substrate by a margin area, and forming the recess may include removing a part of the margin area at the edge of the first substrate.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIGS. 1 and 2 are diagrams illustrating a structure of a general liquid crystal display;
FIGS. 3 and 4 are diagrams illustrating a structure of a liquid crystal display according to the first exemplary embodiment of the present disclosure; and
FIG. 5 is a diagram illustrating a structure of a liquid crystal display according to the second exemplary embodiment of the present disclosure.

### DETAILED DESCRIPTION OF THE EMBODIMENTS

Reference will now be made in detail to embodiments of the invention, examples of which are illustrated in the accompanying drawings. Wherever possible, the same reference numbers will be used throughout the drawings to refer to the same or like parts. It will be paid attention that detailed description of known arts will be omitted if it is determined that the arts can mislead the embodiments of the invention.

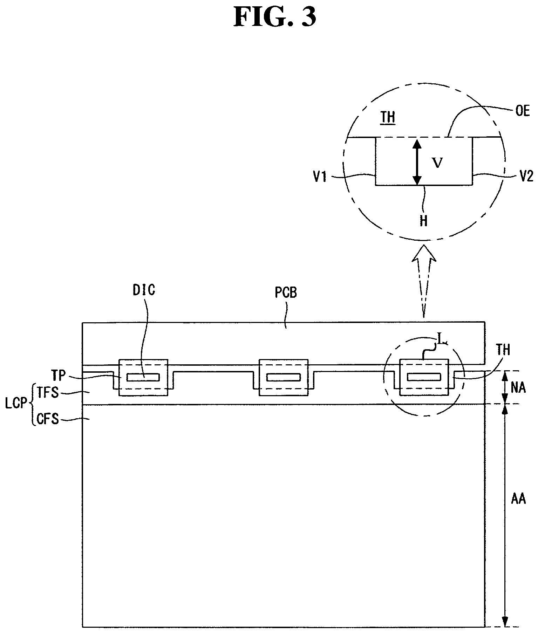

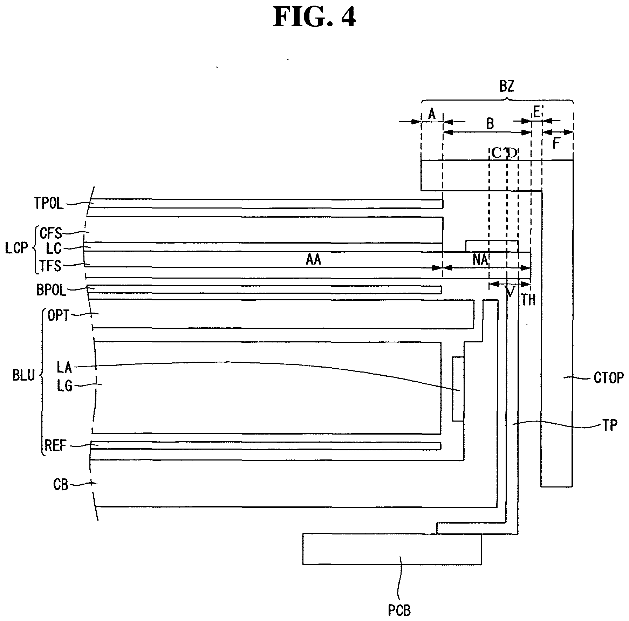

Hereinafter, a flat panel display FPD according to embodiments of the present disclosure will be described by reference to FIGS. 3 and 4. By way of example only, a liquid crystal display will be described, however, the flat panel display according to the present invention is not limited thereto. FIGS. 3 and 4 are a plan view and a cross-sectional view schematically illustrating a structure of a liquid crystal display according to the first exemplary embodiment of the present disclosure.

The liquid crystal display according to an exemplary embodiment of the present disclosure includes a display panel LCP, a backlight unit BLU that emits light to the display panel LCP, and a driving unit that drives the display panel LCP.

The display panel LCP includes a thin transistor substrate (TFS, or a lower substrate) on which a display area AA and a non-display area NA are defined, a color filter substrate (CFS, or an upper substrate) that is disposed on the display area AA, and a liquid crystal cell LC that is sandwiched between the thin film transistor substrate TFS and the color filter substrate CFS.

A color filter having a pattern of red, green, and blue, or having a pattern of red, green, blue, and white may be formed on the color filter substrate CFS. In addition, a black matrix may be further formed thereon.

A plurality of gate lines that are arranged in a first direction and a plurality of data lines that are arranged in a second direction crossing the first direction may be formed on the TFS. Further, a plurality of pixel electrodes may be arranged in a matrix form in a pixel area defined by the intersection of the gate lines and the data lines. A plurality of thin film transistor substrates TFS that are switched according to a signal of the gate lines to transmit a signal of the data lines to each pixel electrode may be formed.

A liquid crystal cell LC may be driven by a voltage difference between a pixel electrode that charges a data voltage through a thin film transistor and a common electrode to which a common voltage is applied. The common electrode may be formed on the color filter substrate CFS or on the thin film transistor substrate TFS depending on a driving method of a liquid crystal display.

For an optical function of the display panel LCP, a top polarizer TPOL may be disposed on the front surface of the color filter substrate CFS, and a bottom polarizer BPOL may be disposed on the rear surface of the thin film transistor substrate TFS. For a normally black mode, the top polarizer TPOL and the bottom polarizer BPOL need to be disposed in a manner in which respective light transmission axes thereof cross orthogonal to each other. For a normally white mode, the top polarizer TPOL and the bottom polarizer BPOL need to be disposed in a manner in which respective light transmission axes thereof become in parallel.

The backlight unit BLU may be disposed on the rear surface of the display panel LCP, and may include a light source LA that generates light and a light guide plate LG that guides light from the light source LA to the display panel LCP. A reflection sheet REF may be disposed on the rear surface of the light guide plate LG. Further, an optical sheet may be disposed on the front surface of the light guide plate LG. The optical sheet OPT may include a diffusion sheet, a prism sheet, or a protective sheet.

A cover bottom CB may be disposed on the bottom of the display panel LCP and the backlight unit BLU. The cover bottom CB needs to be formed in a manner that protects and supports the display panel LCP and the backlight unit BLU.

A driving unit that drives the display panel LCP may be provided on at least one end side of the thin film transistor substrate TFS. The driving unit may include a Printed Circuit Board (PCB) to drive the display panel LCP, and a drive integrated circuit (DIC) that is electrically connected to the PCB to supply signals to the display panel LCP. The DIC may supply signals to the gate lines or the data lines through a pad unit formed in the non-display area NA of the thin film transistor substrate TFS. The DIC may be mounted on the connection member TP. For example, the connection member TP may be a Tape Carrier Package (TCP), in which one side of the connection member TP is connected to the thin film transistor substrate TFS by Tape Automated Bonding (TAB), and the other side thereof is connected to the PCB. As illustrated in FIG. 4, the PCB may be disposed on the rear surface of the display panel LCP, e.g. on the rear surface of the BLU, preferably on the rear surface of the cover bottom CB.

A recess TH is formed on an end side or edge OE of the non-display area NA on the thin film transistor substrate TFS. The edge OE may be the edge of the thin film transistor substrate TFS at which the driving unit for driving the display panel LCP is provided. The recess TH may be formed by removing (or cutting) a predetermined area from the edge OE of the thin film transistor substrate TFS.

The recess TH includes a horizontal or parallel side H which may be spaced apart in parallel from the edge OE of the thin film transistor substrate TFS, and the first and second connecting sides V1 and V2 that are extended, e.g. vertically, from two ends of the parallel side H toward the edge OE of the thin film transistor substrate TFS. In other words, the recess TH has a length H in a direction parallel to or along the edge OE. Further, the recess TH has a width V in a direction perpendicular to the edge OE. The connection member TP is arranged within the recess TH between the parallel side H and the edge OE of the thin film transistor substrate TFS. That is, from the side view or cross-sectional view, the connection member TP may be disposed in order not to protrude from the edge OE of the thin film transistor substrate TFS toward the case top CTOP. Thus, the connection member TP may penetrate the non-display area NA of the display panel LCP, i.e. the non-display area NA of the thin film transistor substrate TFS. That is, the connection member TP may be arranged within the recess TH of the non-display area NA of the display panel LCP.

When bending or arching over the parallel side H to the rear surface of the recess, the connection member TP is preferably spaced apart at a predetermined distance C' from the parallel side H of the recess TH. The distance C' between the connection member TP and the parallel side H of the recess TH is preferably less than the distance between the edge OE of the thin film transistor substrate TFS and the parallel side H of the recess TH, i.e. less than the width V of the recess TH. Preferably, the connection member TP is disposed within the inner space of the recess TH so as not to deviate from the non-display area NA of the thin film transistor substrate TFS. That is, a sum of the distance C' between the connection member TP and the parallel side H of the recess TH and the thickness D of the connection member TP is preferably less than the width of the recess TH. In this case, at least a part of a required distance E between the connection member TP and the case top CTOP may also be provided within the recess TH. Thus, the recess TH may compensate at least for the distance C' between the connection member TP and the parallel side H of the recess TH and the thickness D of the connection member TP, and preferably also for a part of the distance E between the connection member TP and the case top CTOP. In one embodiment, the width V of the recess TH may be equal to or greater than the sum of the distance C' between the connection member TP and the parallel side H of the recess TH and the thickness D of the connection member TP: V ≥ C'+D. Preferably, the width V of the recess TH is equal to or less than the sum of the distance C' between the connection member TP and the parallel side H of the recess TH, the distance E between the connection member TP and the case top CTOP and the thickness D of the connection member TP: V ≤ C'+D+E.

In case that a pad unit formed on the non-display area NA has a fixed size, the more the width V of the recess TH, e.g. the lengths of the first connecting side V1 and the second connecting side V2, increases, the more a size occupied by the non-display area NA on the thin film transistor substrate TFS increases. Thus, the first connecting side V1 and the second connecting side V2 desirably have a minimum length, that is the recess TH preferably has a minimum width V = C'+D, so that the bent connection member TP does not protrude from the non-display area NA.

In addition, when manufacturing the thin film transistor substrate TFS, the pad unit may be disposed with a margin area spaced apart from the edge OE of the thin film transistor substrate TFS. After the thin film transistor substrate TFS is manufactured, part of the margin area between the edge OE of the thin film transistor substrate TFS and the pad unit is cut to form a recess TH, thereby resulting in a narrow bezel structure. If the recess TH is first formed on the thin film transistor substrate TFS and then a pad unit is formed on a parallel side H of the recess TH, the pad unit needs to have a margin area spaced apart from the parallel side H, and thus, a narrow bezel structure may not be achieved. That is, the pad unit is formed with a margin area from the thin film transistor substrate TFS, and the recess is formed on the margin area, thereby reducing the size of the non-display area NA on the thin film transistor substrate TFS.

The parallel side H of the recess TH is long enough for the connection member TP to pass through the recess TH, thereby preventing a damage caused by direction friction between the recess TH and the connection member TP having ductility properties. Preferably, the length of the parallel side H of the recess TH, i.e. the length of the recess TH, is equal to or longer than the horizontal length L of the connection member TP (cf. Fig. 3).

If necessary, there may be a plurality of connection members TP, and a plurality of recesses TH may be respectively formed corresponding to the plurality of connection members on the edge OE of the thin film transistor substrate TFS. That is, each of the plurality of connection members may be respectively provided in one of the plurality of recesses TH. At this point, an edge of the non-display area NA of the thin film transistor substrate TFS is formed to have an uneven shape. Alternatively or additionally, there may be a plurality of connection members TP provided in one recess TH through which the connection members TP pass. In this case, the connection members TP need to be disposed at predetermined distance from each other.

The shape of the recess may be various. For example, as illustrated in the drawings, parallel side H of the recess TH and each of the connecting sides V1 and V2 thereof may form a right angle. At this point, the parallel side H may be long enough for the connection member TP to pass through, i.e. longer than the length L of the connection member TP.

In another example, the parallel side H of the recess TH and at least one of the connecting sides V1 and V2 thereof may form an acute angle. In this case, the recess TH may surround the connection member TP that pass through the recess TH, thereby fixing the connection member TP not to be separated from the recess TH.

A case top CTOP may be disposed to cover an edge of the color filter substrate CFS, the thin film transistor substrate TFS, and the driving unit. The connection member TP is preferably disposed to pass through the recess TH so as not to protrude from an edge OE of the thin film transistor substrate TFS. Accordingly, a sufficient distance between the connection member TP and the case top CTPO can be provided to prevent a damage of the connection member TP having ductility properties, while reducing a bezel width BZ. That is, it may be enough to provide a width E' of a processing margin area, i.e. a distance E' between the case top CTPO and the edge OE of the thin film transistor substrate TFS. Thus, a narrow distance between the case top CTPO and the edge OE of the thin film transistor substrate TFS, may be secured. Preferably, the distance E between the connection member TP and the case top CTPO is larger than the distance E' between the non-display area NA of the display panel LCP and the case top CTOP.

Hereinafter, the liquid crystal display according to the first exemplary embodiment of the present disclosure will be compared with the general liquid crystal display by reference to FIGS. 2 and 4.

Referring to FIG. 2, the size of a bezel area BZ of the general liquid crystal display is a sum of the following: a width A of the edge of the color filter substrate CFS, a width B of the non-display area NA of the display panel LCP, i.e. of the thin film transistor substrate TFS, a distance C between an edge of the display panel LCP, i.e. of the thin film transistor substrate TFS, and the connection member TP, a thickness D of the connection member TP, a distance E between the connection member TP and the case top CTPO, and a thickness F of the case top CTOP.

On the other hand, referring to FIG. 4, the size of a bezel area BZ of the liquid crystal display according to the first exemplary embodiment of the present disclosure may be a sum of the following: a width A of the edge of the color filter substrate CFS, a width B of the non-display area NA of the display panel LCP (e.g. of the thin film transistor substrate TFS), a processing margin area E' between the case top CTOP and the edge OE of the display panel LCP (e.g. of the thin film transistor substrate TFS), and a thickness F of the case top CTOP. Accordingly, compared to the bezel area of the general liquid crystal display, the bezel area BZ of the liquid crystal display according to the first exemplary embodiment of the present disclosure is not increased by the distance C between a side of the display panel LCP and the connection member TP (See FIG. 2), the thickness D of the connection member TP (See FIG. 2), and the distance E between the connection member TP and the case top CTOP (See FIG. 2). Instead, at least the distance C' between a side of the display panel LCP and the connection member TP (See FIG. 4) and the thickness D of the connection member TP (See FIG. 4) may be compensated by the recess TH formed in a first or lower substrate of the display panel LCP, and preferably also at least part of the distance E between the connection member TP and the case top CTOP (See FIG. 4).

The liquid crystal display according to the first exemplary embodiment of the present disclosure may have a recess TH formed on the edge OE of a first or lower substrate of the display panel LCP (e.g. the thin film transistor substrate TFS), so that the connection member TP may pass through the recess TH, thereby minimizing the size of the bezel area. In addition, in the present disclosure, the connection member TP having ductility properties is disposed to pass through the recess TH of the thin film transistor substrate TFS, so that direct contact or friction between the connection member TP and other structures, such as the case top CTOP, may be prevented. For this, preferably a distance E' between the display panel LCP and the case top CTOP may be provided. Accordingly, it is possible to prevent damage of the connection member TP.

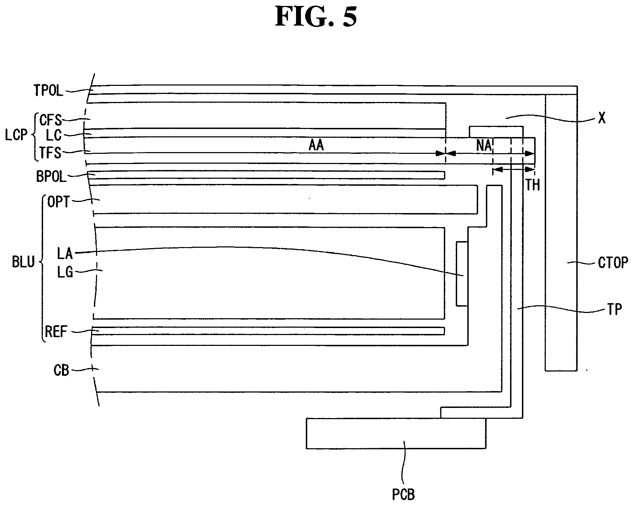

Hereinafter, a liquid crystal display according to the second exemplary embodiment of the present disclosure will be described by reference to FIG. 5. FIG. 5 is a diagram illustrating a structure of the liquid crystal display according to the second exemplary embodiment of the present disclosure. As mentioned above, the liquid crystal display is merely one example for a flat panel display, without being limited thereto. In the following, descriptions about elements having reference numerals and functions identical to those provided with the liquid crystal display according to the first exemplary embodiment of the present disclosure are omitted for convenience of explanation.

The second exemplary embodiment of the present disclosure may achieve a non-bezel liquid crystal display. For example, a top polarizer TPOL disposed on a color filter substrate CFS may cover even an area of the thin film transistor substrate TFS, i.e. the area NA which is extended longer than the color film substrate CFS. That is, the top polarizer TPOL may be disposed on the color filter substrate CFS and the non-display area NA of the thin film transistor substrate TFS. At this point, a case top CTOP may be disposed on the rear surface of one end of the extendedly disposed top polarizer TPOL. The case top CTOP is disposed on the rear surface of the top polarizer TPOL, so that a user cannot see the case top CTOP from the front view. In other words, the front surface of the flat panel display may be formed by the top polarizer TPOL.

A step formed between the top polarizer TPOL and the thin film transistor substrate TFS results in a space X. The space X between the top polarizer TPOL and the thin film transistor substrate TFS may be filled with buffer materials or with an additional auxiliary substrate, e.g. including materials of the color film substrate CFS. By filling the gap between the top polarizer TPOL and the thin film transistor substrate TFS, it is possible to prevent the top polarizer TPOL from coming off. In addition, applying buffer materials may prevent contact between adjacent members, thereby preventing damage of the members. Accordingly, the second exemplary embodiment of the present disclosure may achieve a non-bezel liquid crystal display with a four-surface borderless structure. Also a thickness of the display device can be reduced.

However, aspects of the present disclosure are not limited thereto, and the second exemplary embodiment of the present disclosure includes any structure that allows a user not to see the non-display area NA of the color filter substrate CFS, the driving unit, and the case top CTOP from the front view.

In the aforementioned exemplary embodiments, a liquid crystal display is described for convenience of explanation, but aspects of the present disclosure are not limited thereto. Thus, the present disclosure may be applied to any flat panel display FPD which has a driving unit and a display panel separately, wherein the driving unit is mounted on the rear surface of the display panel. Examples of the FPD may include a Liquid Crystal Display Device (LCD), a Plasma Display Panel (PDP), an Organic Light Emitting Display Device (OLED), an Electrophoretic Display Device (EPD), and the like.

Although embodiments have been described with reference to a number of illustrative embodiments thereof, it should be understood that numerous other modifications and embodiments can be devised by those skilled in the art that will fall within the scope of the claims. More particularly, various variations and modifications are possible in the component parts and/or arrangements of the subject combination arrangement within the scope of the appended claims. In addition to variations and modifications in the component parts and/or arrangements, alternative uses will also be apparent to those skilled in the art.

## Claims

1. A flat panel display (FPD) device, including:
a display panel (LCP) including a first substrate (TFS);
a driving unit (PCB) for driving the display panel (LCP), wherein the driving unit is mounted on a rear surface of the display panel (LCP);
a connection member (TP) for electrically connecting the driving unit and the first substrate (TFS) of the display panel (LCP); **characterised by**
a recess (TH) formed on an edge (OE) of the first substrate (TFS), wherein the connection member (TP) passes through the recess (TH) and is bent around the first substrate (TFS) to the rear surface of the display panel (LCP).

2. The flat panel display device of claim 1, wherein the recess (TH) is formed in a non-display area (NA) of the first substrate (TFS).

3. The flat panel display device of claim 1 or 2, wherein the recess (TH) has a parallel side (H) that is parallel to the edge (OE) of the first substrate (TFS) and two connecting sides (V1, V2) connecting respectively an end of the parallel side (H) to the edge (OE) of the first substrate (TFS).

4. The flat panel display device of claim 3, wherein a width (V) of the recess (TH) perpendicular to the edge (OE) is equal to or greater than a sum of a distance (C') between the connection member (TP) and the parallel side (H) of the recess (TH), and the thickness (D) of the connection member (TP).

5. The flat panel display device of claim 3 or 4, further including a case top (CTOP) covering at least a lateral surface of the first substrate (LCP) corresponding to the edge (OE).

6. The flat panel display device of claim 5, wherein the edge (OE) of the first substrate (TFS) is spaced apart from the case top (CTOP) by a distance (E') in a direction perpendicular to the lateral surface of the first substrate (TFS).

7. The flat panel display device of claim 5 or 6, wherein a width (V) of the recess (TH) perpendicular to the edge (OE) is equal to or greater than a distance (E') between the edge (OE) of the first substrate (TFS) and the case top (CTOP).

8. The flat panel display device of claim 5, 6, or 7, further comprising a second substrate (CFS) and a top polarizer (TPOL), the top polarizer (TPOL) covering a front surface of the second substrate (CFS) and an non-display area (NA) of the first substrate (TFS), where the recess (TH) is formed.

9. The flat panel display device of claim 8, wherein the case top (CTOP) is disposed on a rear surface of the top polarizer (TPOL).

10. The flat panel display device of claim 8 or 9, wherein a space (X) between the top polarizer (TPOL) and the first substrate (TFS) is filled with a buffer material.

11. The flat panel display device according to any one of the preceding claims, wherein a plurality of connection members (TP) is provided in the recess (TH).

12. The flat panel display device according to any one of the preceding claims, wherein a plurality of recesses (TH) is provided.

13. The flat panel display device according to any one of the preceding claims, wherein the flat panel display (FPD) device is a liquid crystal display (LCD) device and the first substrate (TFS) is a thin film transistor substrate, on which a plurality of gate lines and a plurality of data lines are formed.

14. A method of manufacturing a flat panel display (FPD) device having a driving unit (PCB) for driving the display panel (LCP) mounted on a rear surface of the display panel (LCP), the method including the steps of:
preparing a first substrate (TFS);
forming a recess (TH) on an edge (OE) of the first substrate (TFS); and
connecting the driving unit and the first substrate (TFS) electrically by means of a connection member (TP), wherein the connection member (TP) passes through the recess (TH) and is bent around the first substrate (TFS) to the rear surface of the display panel.

15. The method of claim 14, wherein preparing the first substrate (TFS) includes disposing a pad unit spaced apart from the edge (OE) of the first substrate (TFS) by a margin area, and forming the recess (TH) includes removing a part of the margin area at the edge (OE) of the first substrate (TFS).

## Patentansprüche

1. Flachbildschirmvorrichtung (FPD), die Folgendes umfasst:
ein Anzeigefeld (LCP), das ein erstes Substrat (TFS) umfasst;
eine Ansteuereinheit (PCB) zum Ansteuern des Anzeigefelds (LCP), wobei die Ansteuereinheit an einer hinteren Oberfläche des Anzeigefelds (LCP) angebracht ist;
ein Verbindungselement (TP) zum elektrischen Verbinden der Ansteuereinheit und des ersten Substrats (TFS) des Anzeigefelds (LCP); **gekennzeichnet durch**
eine Vertiefung (TH), die an einer Kante (OE) des ersten Substrats (TFS) ausgebildet ist, wobei das Verbindungselement (TP) **durch** die Vertiefung (TH) verläuft und um das erste Substrat (TFS) zu der hinteren Oberfläche des Anzeigefelds (LCP) gebogen ist.

2. Flachbildschirmvorrichtung nach Anspruch 1, wobei die Vertiefung (TH) in einem Bereich (NA) des ersten Substrats (TFS) ausgebildet ist, der nicht zur Anzeige gehört.

3. Flachbildschirmvorrichtung nach Anspruch 1 oder 2, wobei die Vertiefung (TH) eine parallele Seite (H), die zu der Kante (OE) des ersten Substrats (TFS) parallel verläuft, und zwei Verbindungsseiten (V1, V2), die jeweils ein Ende der parallelen Seite (H) mit der Kante (OE) des ersten Substrats (TFS) verbinden, umfasst.

4. Flachbildschirmvorrichtung nach Anspruch 3, wobei eine Breite (V) der Vertiefung (TH) senkrecht zu der Kante (OE) gleich oder größer als eine Summe eines Abstands (C') zwischen dem Verbindungselement (TP) und der parallelen Seite (H) der Vertiefung (TH) und der Dicke (D) des Verbindungselements (TP) ist.

5. Flachbildschirmvorrichtung nach Anspruch 3 oder 4, die ferner eine Gehäuseoberseite (CTOP) umfasst, die wenigstens eine seitliche Oberfläche des ersten Substrats (LCP), die der Kante (OE) entspricht, bedeckt.

6. Flachbildschirmvorrichtung nach Anspruch 5, wobei die Kante (OE) des ersten Substrats (TFS) von der Gehäuseoberseite (CTOP) in einer Richtung senkrecht zu der seitlichen Oberfläche des ersten Substrats (TFS) um einen Abstand (E') beabstandet ist.

7. Flachbildschirmvorrichtung nach Anspruch 5 oder 6, wobei eine Breite (V) der Vertiefung (TH) senkrecht zu der Kante (OE) gleich einem oder größer als ein Abstand (E') zwischen der Kante (OE) des ersten Substrats (TFS) und der Gehäuseoberseite (CTOP) ist.

8. Flachbildschirmvorrichtung nach Anspruch 5, 6 oder 7, die ferner ein zweites Substrat (CFS) und einen oberen Polarisationsfilter (TPOL) umfasst, wobei der obere Polarisationsfilter (TPOL) eine vordere Oberfläche des zweiten Substrats (CFS) und einen Bereich (NA) des ersten Substrats (TFS), der nicht zur Anzeige gehört, dort bedeckt, wo die Vertiefung (TH) ausgebildet ist.

9. Flachbildschirmvorrichtung nach Anspruch 8, wobei die Gehäuseoberseite (CTOP) an einer hinteren Oberfläche des oberen Polarisationsfilters (TPOL) angeordnet ist.

10. Flachbildschirmvorrichtung nach Anspruch 8 oder 9, wobei ein Raum (X) zwischen dem oberen Polarisationsfilter (TPOL) und des ersten Substrats (TFS) mit einem Puffermaterial gefüllt ist.

11. Flachbildschirmvorrichtung nach einem der vorhergehenden Ansprüche, wobei mehrere Verbindungselemente (TP) in der Vertiefung (TH) vorgesehen sind.

12. Flachbildschirmvorrichtung nach einem der vorhergehenden Ansprüche, wobei mehrere Vertiefungen (TH) vorgesehen sind.

13. Flachbildschirmvorrichtung nach einem der vorhergehenden Ansprüche, wobei die Flachbildschirmvorrichtung (FPD) eine Flüssigkristallanzeigevorrichtung (LCD) ist und wobei das erste Substrat (TFS) ein Dünnschichttransistor-Substrat ist, auf dem mehrere Gate-Leitungen und mehrere Datenleitungen gebildet sind.

14. Verfahren zum Herstellen einer Flachbildschirmvorrichtung (FPD), die eine Ansteuereinheit (PCB) zum Ansteuern des Anzeigefelds (LCP) umfasst, die an einer hinteren Oberfläche des Anzeigefelds (LCP) angebracht ist, wobei das Verfahren die folgenden Schritte umfasst:
Herstellen eines ersten Substrats (TFS);
Bilden einer Vertiefung (TH) an einer Kante (OE) des ersten Substrats (TFS); und
elektrisches Verbinden der Ansteuereinheit und des ersten Substrats (TFS) mittels eines Verbindungselements (TP), wobei das Verbindungselement (TP) durch die Vertiefung (TH) verläuft und um das erste Substrat (TFS) zu der hinteren Oberfläche des Anzeigefelds gebogen ist.

15. Verfahren nach Anspruch 14, wobei das Herstellen des ersten Substrats (TFS) ein Abscheiden einer Kontaktstelleneinheit, die von der Kante (OE) des ersten Substrats (TFS) durch einen Randbereich beabstandet ist, umfasst, und wobei das Ausbilden der Vertiefung (TH) das Entfernen eines Teils des Randbereichs bei der Kante (OE) des ersten Substrats (TFS) umfasst.

## Revendications

1. Dispositif d'affichage à écran plat (FPD), comprenant :
un écran d'affichage (LCP) comprenant un premier substrat (TFS) ;
une unité de commande (PCB) pour commander l'écran d'affichage (LCP), dans lequel l'unité de commande montée sur une surface arrière de l'écran d'affichage (LCP) ;
un organe de raccordement (TP) pour raccorder électriquement l'unité de commande et le premier substrat (TFS) de l'écran d'affichage (LCP) ; **caractérisé par**
un évidement (TH) formé sur un bord (OE) du premier substrat (TFS), dans lequel l'organe de raccordement (TP) passe à travers l'évidement (TH) et est plié autour du premier substrat (TFS) sur la surface arrière de l'écran d'affichage (LCP).

2. Dispositif d'affichage à écran plat selon la revendication 1, dans lequel l'évidement (TH) est formé dans une zone de non-affichage (NA) du premier substrat (TFS).

3. Dispositif d'affichage à écran plat selon la revendication 1 ou 2, dans lequel l'évidement (TH) comporte un côté parallèle (H) qui est parallèle au bord (OE) du premier substrat (TFS) et deux côtés de raccordement (V1, V2) raccordant respectivement une extrémité du côté parallèle (H) au bord (OE) du premier substrat (TFS).

4. Dispositif d'affichage à écran plat selon la revendication 3, dans lequel une largeur (V) de l'évidement (TH) perpendiculaire au bord (OE) est supérieure ou égale à une somme d'une distance (C') entre l'organe de raccordement (TP) et le côté parallèle (H) de l'évidement (TH), et l'épaisseur (D) de l'organe de raccordement (TP).

5. Dispositif d'affichage à écran plat selon la revendication 3 ou 4, comprenant en outre un dessus de boîtier (CTOP) recouvrant au moins une surface latérale du premier substrat (LCP) correspondant au bord (OE).

6. Dispositif d'affichage à écran plat selon la revendication 5, dans lequel le bord (OE) du premier substrat (TFS) est espacé du dessus de boîtier (CTOP) d'une distance (E') dans un sens perpendiculaire à la surface latérale du premier substrat (TFS).

7. Dispositif d'affichage à écran plat selon la revendication 5 ou 6, dans lequel une largeur (V) de l'évidement (TH) perpendiculaire au bord (OE) est supérieure ou égale à une distance (E') entre le bord (OE) du premier substrat (TFS) et le dessus de boîtier (CTOP).

8. Dispositif d'affichage à écran plat selon la revendication 5, 6 ou 7, comprenant en outre un deuxième substrat (CFS) et un polariseur de dessus (TPOL), le polariseur de dessus (TPOL) recouvrant une surface avant du deuxième substrat (CFS) et une zone de non-affichage (NA) du premier substrat (TFS) où l'évidement (TH) est formé.

9. Dispositif d'affichage à écran plat selon la revendication 8, dans lequel le dessus de boîtier (CTOP) est disposé sur une surface arrière du polariseur de dessus (TPOL).

10. Dispositif d'affichage à écran plat selon la revendication 8 ou 9, dans lequel un espace (X) entre le polariseur de dessus (TPOL) et le premier substrat (TFS) est rempli d'un matériau tampon.

11. Dispositif d'affichage à écran plat selon l'une quelconque des revendications précédentes, dans lequel une pluralité d'organes de raccordement (TP) sont prévus dans l'évidement (TH).

12. Dispositif d'affichage à écran plat selon l'une quelconque des revendications précédentes, dans lequel une pluralité d'évidements (TH) sont prévus.

13. Dispositif d'affichage à écran plat selon l'une quelconque des revendications précédentes, dans lequel le dispositif d'affichage à écran plat (FPD) est un dispositif d'affichage à cristaux liquides (LCD) et le premier substrat (TFS) est un substrat de transistor à film mince sur lequel une pluralité de lignes de grille et une pluralité de lignes de données sont formées.

14. Procédé de fabrication d'un dispositif d'affichage à écran plat (FPD) comportant une unité de commande (PCB) pour commander l'écran d'affichage (LCP) monté sur une surface arrière de l'écran d'affichage (LCP), le procédé comprenant les étapes de :
la préparation d'un premier substrat (TFS) ;
la formation d'un évidement (TH) sur un bord (OE) du premier substrat (TFS) ; et
le raccordement électrique de l'unité de commande et du premier substrat (TFS) au moyen d'un organe de raccordement (TP), dans lequel l'organe de raccordement (TP) passe à travers l'évidement (TH) et est plié autour du premier substrat (TFS) sur la surface arrière de l'écran d'affichage.

15. Procédé selon la revendication 14, dans lequel la préparation du premier substrat (TFS) comprend la disposition d'une unité de pavé espacée du bord (OE) du premier substrat (TFS) d'une zone de marge, et la formation de l'évidement (TH) comprend l'enlèvement d'une partie de la zone de marge au bord (OE) du premier substrat (TFS).
